# EUROPEAN PATENT APPLICATION

(11) **EP 0 586 113 A2**
(43) Date of publication of application: **09.03.1994**
(21) Application number: 93306301.8
(22) Date of filing: 10.08.1993
(51) Int. Cl.: H03M 1/14, H03M 1/36

(54) **Analog-to-digital converter**

(30) Priority: 31.08.1992 US 937974
(71) Applicant: ADVANCED MICRO DEVICES, INC., Sunnyvale, CA 94088 (US)
(72) Inventor: Moyal,Miki Z., Austin Texas 78757 (US); Stewart, Brett, Austin, Texas 78703-2931 (US)
(74) Representative: Wright, Hugh Ronald

(57) **Abstract**

An apparatus for converting received analog signals to digital signals comprising an analog-to-digital converting unit including a first converting section for generating a most-significant segment of the digital signal, and includes a second converting section for generating a least-significant segment of the digital signal. The apparatus further comprises a multiplexing unit for presenting samples of the received analog signals to the analog-to-digital converting unit and a combining unit for combining the most-significant segment with the least-significant segment to generate an output digital signal. Each analog signal is received by the multiplexing unit via a respective input channel, and the multiplexing unit delivers the analog signals to the converting unit in a predetermined sequence. Each analog signal is delivered in a first sample packet to the first converting section in response to a first clocking signal and is delivered in a second sample packet to the second converting section in response to a second clocking signal. The second clocking signal preferably follows the first clocking signal in sufficiently short a time with respect to the period of the analog signal that the first sample packet and the second sample packet essentially are the same sample of the analog signal.

## Description

In many employments of digital signal processing devices, original information to be manipulated by a digital signal processor is received in analog form and must, therefore, be converted to a digital representation of the received analog signal for use by the digital signal processor. Such conversion is commonly effected by taking successive samples of the received analog signal and converting each successive sample to a digital word, or byte, which is composed of a plurality of digits, or bits, hierarchically arranged from a least-significant bit to a most-significant bit. The sampling rate, or the speed of conversion, is directly related to the accuracy of representation of the received analog signal by successive digital bytes. Thus, more frequent sampling and conversion of the received analog signal yields successive digital bytes which comprise a digital signal output of a converter device more accurately representative of the received analog signal.

Speed of conversion, or sampling rate, is an even more critical factor in accuracy of digital representation of a received analog signal when one is dealing with a multichannel analog signal input. Multi-channel analog inputs may be, for example, involved in operating a motion controller controlling a read head for a computer memory device such as a disc drive. Such a motion controller involves analog signals to control movement of a read head in at least two dimensions, to represent data conveyed from the memory device, to sense correct location within a given track of memory in the memory device, and sometimes to control or monitor other parameters.

There is, therefore, an advantage in increasing sampling speed (and, thus, increasing speed of conversion) for an analog-to-digital converting apparatus to provide increased accuracy in digital representation of received analog signals and to increase responsiveness of a digital device to analog signals.

We will describe a partitioned analog-to-digital converting apparatus which operates in cooperation with a multiplexing device for multiplexing analog inputs to various partitions of the converter apparatus to provide an increased sampling rate, increased conversion speed, and increased responsiveness.

We will describe an apparatus for converting a plurality of received analog signals to a plurality of output digital signals, each respective analog signal being received at a respective input channel and being converted to a respective output digital signal.

The apparatus comprises an analog-to-digital converting unit for effecting conversion of a sample of a received analog signal to a digital representation of the sample. The digital representation of the sample has a predetermined number of digits, or bits, hierarchically arranged from a least-significant bit to a most-significant bit. The analog-to-digital converting unit includes a first converting section for generating a most-significant segment of the digital representation, and includes a second converting section for generating a least-significant segment of the digital representation. The most-significant segment is composed of the m most-significant digits of the digital representation; the least-significant segment is composed of the (n-m) least-significant digits of the digital representation, where n = the number of digits in the digital representation.

The apparatus may further comprise a multiplexing unit for presenting samples of the plurality of received analog signals to the analog-to-digital converting unit. Each respective analog signal is received by the multiplexing unit via a respective input channel, and the multiplexing unit is operatively connected with the analog-to-digital converting unit for delivering the analog signals to the converting unit in a predetermined sequence. Each respective analog signal is delivered in a first sample packet to the first converting section of the converting unit in response to a first clocking signal and is delivered in a second sample packet to the second converting section of the converting unit in response to a second clocking signal. The second clocking signal preferably follows the first clocking signal in sufficiently short a time with respect to the period of the analog signal that the first sample packet and the second sample packet essentially are the same sample of the analog signal.

The apparatus may further comprise a combining unit for combining the most-significant segment with the least-significant segment of each respective digital representation to generate an output digital signal.

We will describe
an apparatus for converting a plurality of received analog signals to a plurality of output digital signals which employs a partitioned analog-to-digital converter employing a first conversion section for generating most-significant segments of a digital representation and employing a second converter section for generating a least-significant segment of a digital representation.

We will describe
an apparatus for converting a plurality of received analog signals to a plurality of representative output digital signals which employs a multiplexer input unit for providing a plurality of analog signals to a partitioned converter unit in a first sample packet to the first converting section of the converter unit in response to a first clocking signal and in a second sample packet to the second converting section of the converting unit in response to a second clocking signal.

Further objects and features of the present invention will be apparent from the following specification and claims when considered in connection with the accompanying drawings illustrating the preferred embodiment of the invention.

### DETAILED DESCRIPTION OF THE DRAWINGS

Fig. 1 is a schematic block diagram of a prior art analog-to-digital converting system.

Fig. 2 is a schematic block diagram of an analog-to-digital converter structure appropriate for use with the prior art analog-to-digital converting system illustrated in Fig. 1.

Fig. 3 is a timing diagram illustrating operation of the prior art analog-to-digital converting system illustrated in Fig. 1.

Fig. 4 is a schematic block diagram of the preferred embodiment of the present invention.

Fig. 5 is a schematic block diagram of an analog-to-digital converter appropriate for use with the preferred embodiment of the present invention illustrated in Fig. 4.

Fig. 6 is a timing diagram illustrating operation of the preferred embodiment of the present invention illustrated in Fig. 4.

Fig. 7 is a schematic block diagram of an alternate embodiment of the present invention.

### DETAILED DESCRIPTION OF THE INVENTION

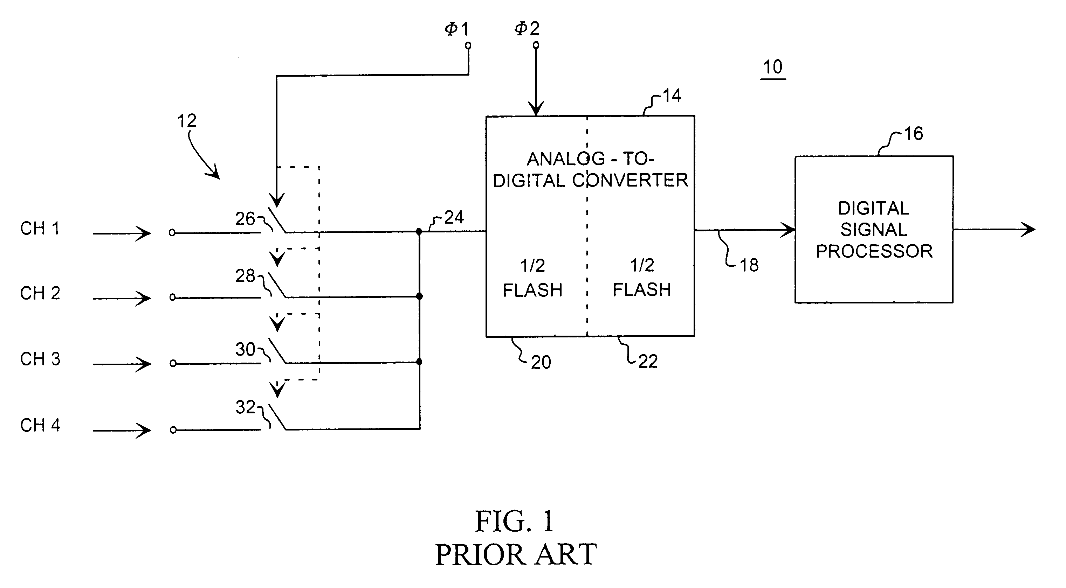

Fig. 1 is a schematic block diagram of a prior art analog-to-digital converting system. In Fig. 1, an analog-to-digital converter system 10 is illustrated as including a multiplexer 12, and a converting device 14 providing digital input to a digital signal processor apparatus 16 via a digital signal bus 18. Converting device 14 may be of a type commonly known by those skilled in the art as a two-stage half flash analog-to-digital converter. Accordingly, converting device 14 comprises a first stage 20 and a second stage 22 and receives an analog signal input on an input line 24 operatively connected with first stage 20. Converting device 14 may be typically of a type of converter described in co-pending application Serial No. 07/882,666, filed May 14, 1992 for "Apparatus for Generating a Digital Signal Output Representative of a Received Analog Signal", and assigned to the assignee of the present application. Converting device 14 is clocked by a clocking signal φ₂ and takes two clock periods to produce a digital signal output on digital signal line 18 representative of an analog signal sample received via input line 24.

Multiplexer 12 provides operative connection between multi-channels channel 1, channel 2, channel 3, and channel 4, and input line 24, respectively through switches 26, 28, 30, 32. Switches 26, 28, 30, 32 are each individually actuable by a clocking signal and, typically, are successively and cyclically actuated by clocking signal φ₁ to present on input line 24 successive samples of analog signals appearing at channels 1, 2, 3, 4.

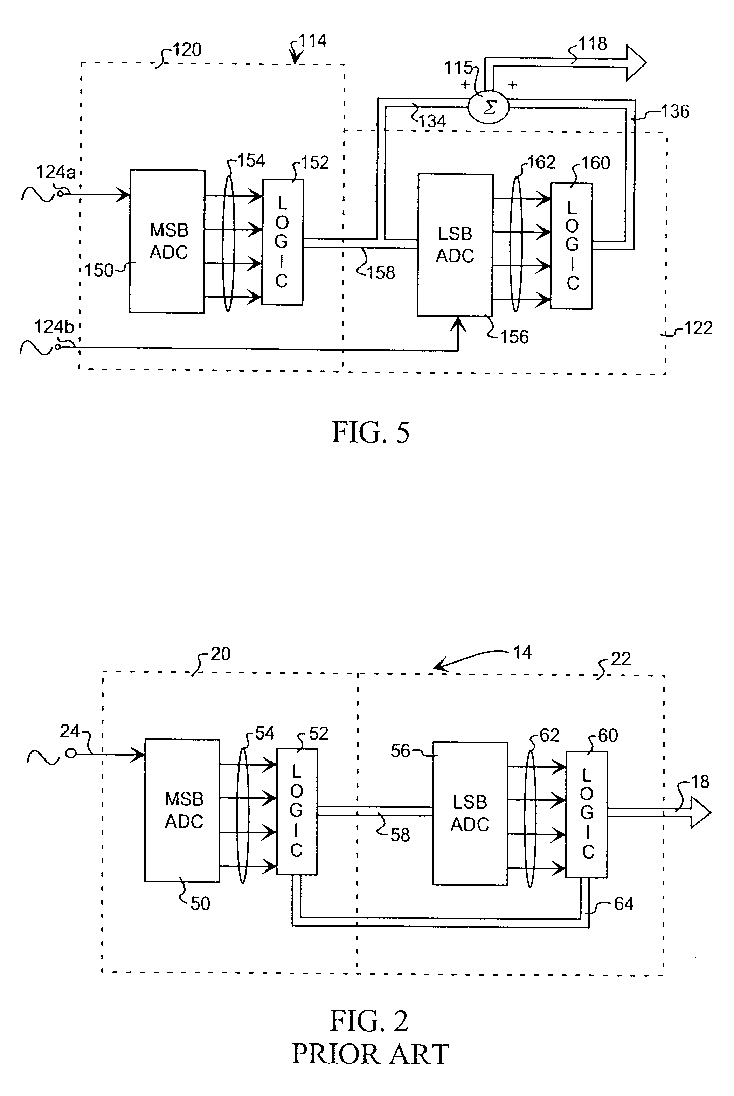

Fig. 2 is a schematic block diagram of an analog-to-digital converter structure appropriate for use with the prior art analog-to-digital converting system illustrated in Fig. 1. In Fig. 2, input line 24 is operatively connected with a most-significant bit analog-to-digital converter unit 50 which generates a most-significant bit segment of a digital representation of the analog signal sample received via input line 24 and presents that most-significant bit segment to a logic unit 52 via a bus 54.

The most-significant bit segment is comprised of the m most-significant bits of the digital representation of the analog signal sample received via input line 24. Logic unit 52 passes the most-significant bit segment to a least-significant bit analog-to-digital converter unit 56 via a bus 58. Least-significant bit analog-to-digital converter unit 56 generates a least-significant bit segment of a digital representation of the analog signal sample received via input line 24 to a logic unit 60 via a bus 62. The least-significant bit segment is comprised of the (n-m) least-significant bits of the digital representation of the analog signal sample received via input line 24, where n equals the number of bits in the digital representation. Logic unit 60 also receives the most-significant bit segment from logic unit 52 via a bus 64. Logic unit 60 employs the most-significant bit segment received via bus 64 and the least-significant bit segment received via bus 62 to generate a digital output signal on digital signal bus 18 which is representative of the analog signal sample received at input line 24.

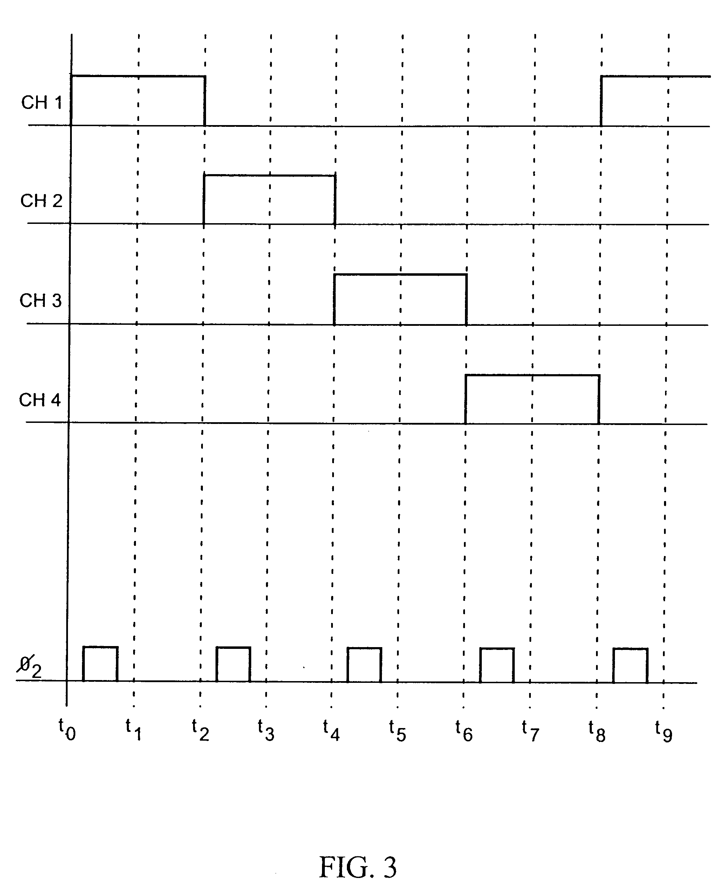

Fig. 3 is a timing diagram illustrating operation of the prior art analog-to-digital converting system illustrated in Fig. 1. In Fig. 3, an analog signal sample is taken at channel 1 by actuation of switch 26 by clocking signal φ₁ between times t₀ and t₁. Clocking signal φ₂ clocks converter unit 14 to initiate analog-to-digital conversion of the analog sample thus provided via input line 24. Conversion of the analog signal sample presented at input line 24, in the embodiment of the analog-to-digital converter unit illustrated in Fig. 2, takes two time periods so that completion of the conversion of the analog signal sample received at input line 24 from channel 1 via switch 26 is completed at time t₂ in Fig. 3.

Clocking signal φ₁ is selectively applied to switch 28 at time t₂, thereby sampling the analog signal received via channel 2 and providing that analog signal sample to converting unit 14 via input line 24. Converting unit 14 is clocked by clocking signal φ₂ during the time period t₂-t₃ and the analog signal sample from channel 2 received via input line 24 is completely converted to a digital output signal appearing at digital signal bus 18 at time t₄.

Switch 30 is selectively actuated by clocking signal φ₁ at time t₄, thereby applying an analog signal sample received at channel 3 to input line 24 and, thence, to converting unit 14 which is clocked by clocking signal φ₂, and digital conversion of the analog signal sample received via input line 24 from channel 3 is completed at time t₆.

Switch 32 is selectively actuated by clocking signal φ₁, at time t₆, thereby applying an analog signal sample appearing at channel 4 to input line 24 and, thence, to converting unit 14. Converting unit 14 is clocked by clocking signal φ₂ and digital conversion of the analog signal sample received from channel 4 via input line 24 is completed at time t₈.

Pursuant to the sequential cyclical actuation scheme of multiplexer 12, switch 26 is again actuated by clocking signal φ₁ at time t₈ to sample the analog signal appearing at channel 1, to provide that analog signal sample to input line 24 and, thence, to converting unit 14 for conversion.

Thus, conversion of samples of the analog signals received at channels 1-4 is completed by the prior art device illustrated in Fig. 1 for a given channel multiplexing cycle in eight time periods, i.e., during the interval t₀-t₈.

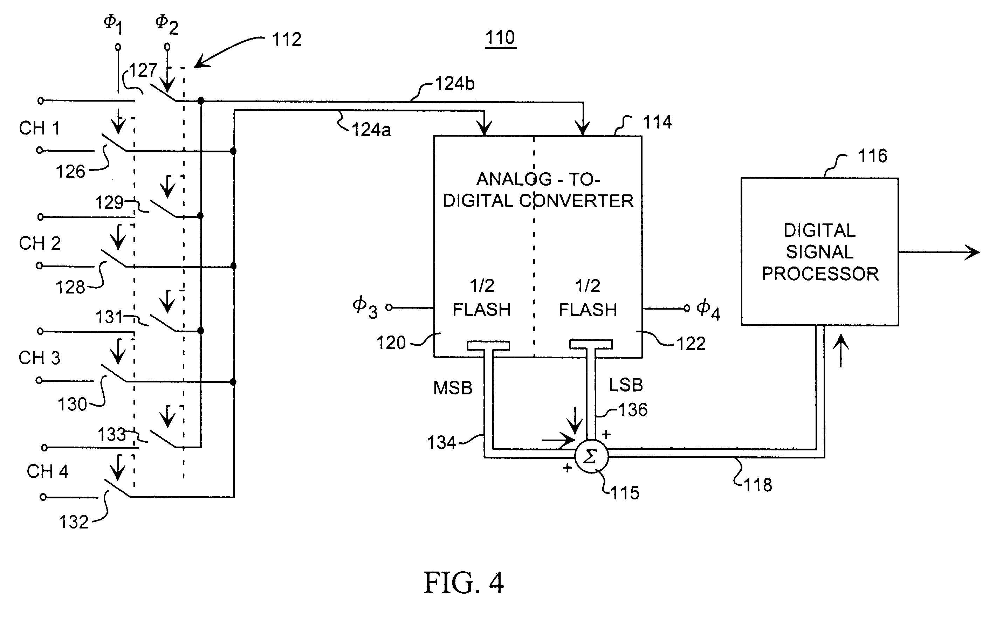

Fig. 4 is a schematic block diagram of the preferred embodiment of the present invention. In Fig. 4, an analog-to-digital converter system 110 is comprised of a multiplexer 112, a converting unit 114, and a combining unit 115 to provide a digital signal to a digital signal processor 116 via a digital signal bus 118. Converting unit 114 includes a first converting section 120 and a second converting section 122; first converting section 120 is clocked by a clocking signal φ₃ and second converting section 122 is clocked by a clocking signal φ₄. Analog signal samples are received by first converting section 120 via an analog input line 124a and second converting section 122 receives analog signal samples via an analog input line 124b.

Multiplexer 112 accommodates received analog signals from channel 1, channel 2, channel 3, and channel 4, separately sampling those respective analog signals and providing analog signal samples to first converting section 120 and second converting section 122. Thus, received analog signals arriving via channel 1 are sampled and analog signal samples are provided to first converting section 120 through a switch 126 in response to clocking signal φ₁ and are sampled and analog signal samples are provided to second converting section 122 via a switch 127 in response to clocking signal φ₂. Received analog signals arriving via channel 2 are sampled and analog signal samples are provided to first converting section 120 via a switch 128 in response to clocking signal φ₁ and are sampled and analog signal samples are provided to second converting section 122 via a switch 129 in response to clocking signal φ₂. Received analog signals arriving via channel 3 are sampled and analog signal samples are provided to first converting section 120 via a switch 130 in response to clocking signal φ₁ and are sampled and analog signal samples are provided to second converting section 122 via a switch 131 in response to clocking signal φ₂. Received analog signals arriving via channel 4 are sampled and analog signal samples are provided to first converting section 120 via a switch 132 in response to clocking signal φ₁ and are sampled and analog signal samples are provided to second converting section 122 via a switch 133 in response to clocking signal φ₂.

Most-significant bit segments of a digital representation of a received analog signal arriving via channels 1-4 (received by converting unit 114 as analog signal samples via analog input line 124a) are passed to combining unit 115 from first converting section 120 via a bus 134. Least-significant bit segments of a digital representation of received analog signals arriving via channels 1-4 (received by converting unit 114 as analog signal samples via analog input line 124b) are passed from second converting section 122 to combining unit 115 via a bus 136. Combining unit 115 combines most-significant bit segments received via bus 134 and least-significant bit segments received via bus 136 to produce a digital representation for each analog signal sample arriving via channels 1-4 and analog input lines 124a, 124b on digital signal bus 118 for provision to digital signal processor 116.

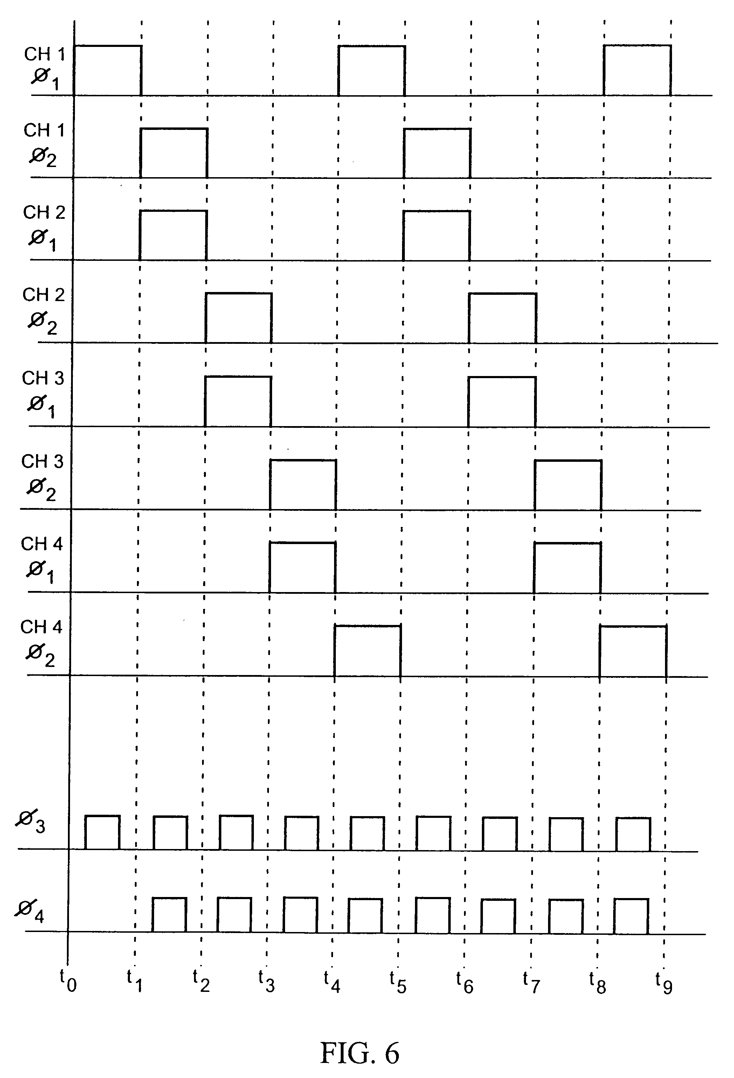

Fig. 5 is a schematic block diagram of an analog-to-digital converter appropriate for use with the preferred embodiment of the present invention illustrated in Fig. 4. In Fig. 5, analog input line 124a is applied to a most-significant bit analog-to-digital converter 150 in first converter section 120. Most-significant bit analog-to-digital converter unit 150 generates a most-significant bit segment of an analog representation of the analog signal samples received via analog input line 124a and conveys that most-significant bit segment to a logic unit 152 via a bus 154. Logic unit 152 provides most-significant bit segment information to a least-significant bit analog-to-digital converter unit 156 via a bus 158. Least-significant bit analog-to-digital converter unit 156 also receives, via analog input line 124b, a sample of the analog signal appearing at one of channels 1-4 as clocked to analog input line 124b by clocking signal φ₂ via a switch 127, 129, 131, or 133. Least-significant bit analog-to-digital converter unit 156 generates a least-significant bit segment of a digital representation of the analog signal sample received via analog input line 124b and conveys that least-significant bit segment to a logic unit 160 via a bus 162.

The most-significant bit segment is comprised of the m most significant bits of the digital representation of a particular analog signal sample. The least-significant bit segment is comprised of the (n-m) least-significant bits of the digital representation of a particular analog signal sample, where n equals the number of bits in the digital representation. The frequency at which clocking signal φ₁ and clocking signal φ₂ are alternatively sampling received analog signals at each channel 1-4 is preferably sufficiently high with respect to the frequencies of the received analog signals at channels 1-4 that, for each received analog signal, a first sample packet (the analog signal sample provided to first converting section 120 in response to clocking signal φ₁) and a second sample packet (the analog signal sample provided to second converting section 122 in response to clocking signal φ₂) are essentially contemporaneous samples of the respective received analog signal being sampled.

Combining unit 115 receives most-significant bit segments via bus 134 and receives least-significant bit segments via bus 136 and generates on digital signal bus 118 a digital representation of the received analog signal arriving via a respective one of channels 1-4 as presently clocked to converting unit 114 by clocking signals φ1 and φ₂.

Preferably, the clocking scheme of multiplexer 112 is a sequentially paired cyclical clocking so that the clocking pattern generally occurs as follows: channel 1, φ₁; channel 1, φ₂; channel 2, φ₁; channel 2, φ₂; channel 3, φ₁; channel 3, φ₂; channel 4, φ₁; channel 4, φ₂; channel 1, φ₁; ..., continuing cyclically.

Thus, referring to Fig. 6, a timing diagram illustrating operation of the preferred embodiment of the present invention illustrated in Fig. 4, the received analog signal arriving via channel 1 is sampled in response to clocking signal φ₁ and the analog signal sample is provided to first converting section 120 via switch 126 and analog input line 124a. First converter section 120 is clocked by clocking signal φ₃ and conversion of the analog signal sample received via analog input line 124a to a most-significant bit segment of a digital representation of that analog signal sample is completed in one cycle, that is, during the interval t₀-t₁. At time t₁, the analog signal arriving via channel 1 is sampled in response to clocking signal φ₂ and the analog signal sample is provided, via switch 127 and analog input line 124b, to second converting section 122 of converting unit 114. Second converting section 122 generates a least-significant bit segment representing the analog signal sample received via analog input line 124b in one clock cycle: interval t₁-t₂. At the same time (i.e., during interval t₁-t₂), the received analog signal arriving via channel 2 is sampled in response to clocking signal φ₁ and the analog signal sample is provided, via switch 128 and analog input line 124a, to first converting section 120 of converting unit 114 and a most-significant bit segment of a digital representation of that analog signal sample is generated by first converting section 120 during the interval t₁-t₂ in response to clocking signal φ₃.

At time t₂, the received analog signal arriving via channel 2 is sampled in response to clocking signal φ₂ and the analog signal sample is provided, via switch 129 and analog input line 124b, to second converting section 122 of converting unit 114. Second converting section 122 generates a least-significant bit segment of a digital representation of that analog signal sample during the interval t₂-t₃. Simultaneously, the received analog signal arriving via channel 3 is sampled in response to clocking signal φ₁ and the analog signal sample is provided, via switch 130 and analog input line 124a, to first converting section 120 of converting unit 114. First converting section 120 generates a most-significant bit segment of a digital representation of that analog signal sample during the interval t₂-t₃.

At time t₃, the received analog signal arriving via channel 3 is sampled in response to clocking signal φ₂ and the analog signal sample is provided, via switch 131 and analog input line 124b, to second converting section 122 of converting unit 114. Second converting section 122 generates a least-significant bit segment of a digital representation of that analog signal sample in response to clocking signal φ₄ during the interval t₃-t₄. Simultaneously, the received analog signal arriving via channel 4 is sampled in response to clocking signal φ₁ and the analog signal sample is provided, via switch 132 and analog input line 124a, to first converting section 120 of converting unit 114. First converting section 120 generates a most-significant bit segment of a digital representation of that analog signal sample in response to clocking signal φ₃ during the interval t₃-t₄.

At time t₄, the received analog signal arriving via channel 4 is sampled in response to clocking signal φ₂ and the analog signal sample is provided, via switch 133 and analog input line 124a, to second converting section 122 of converting unit 114. Second converting section 122 generates a least-significant bit segment of a digital representation of that analog signal during the interval t₄-t₅. At the same time, the cyclic operation of multiplexer 112 samples the received analog signal arriving via channel 1 in response to clocking signal φ₁ and provides an analog signal sample, via switch 126 and analog input line 124a, to first converting section 120 of converting unit 114. First converting section 120 generates a most-significant bit segment of a digital representation of that analog signal sample in response to clocking signal φ₃ during the interval t₄-t₅. The operation of converter system 110 continues in a cyclical manner, as indicated in Fig. 6.

Thus, it can be seen that a full cycle of conversion of received analog signals appearing at channels 1-4 is completed in the space of five time periods, that is, during the interval t₀-t₅. By partitioning converting unit 114 and independently employing first converting section 120 and second converting section 122 in response to individual clocking signals φ₃ and φ₄, and by providing for partitioned provision of analog signals by multiplexer 112 in response to independent clocking signals φ₁ and φ₂, a significant savings in time expended in conversion (i.e., an increase in the sampling rate) is accomplished by the apparatus of the present invention.

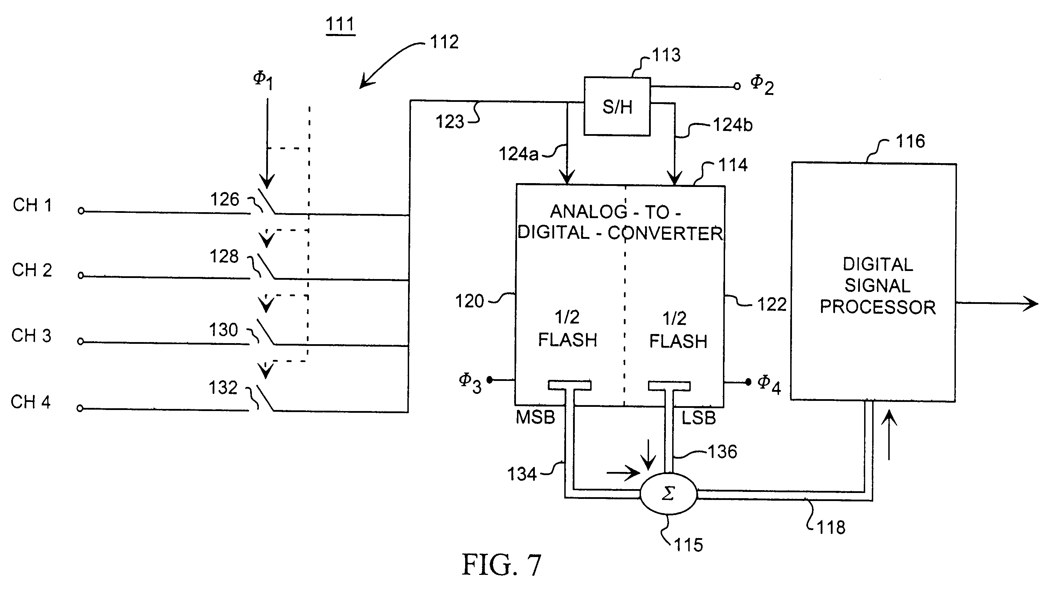

Fig. 7 is a schematic block diagram of an alternate embodiment of the present invention. In order to facilitate understanding of the invention, like elements will be identified by like reference numerals in comparing Figs. 4 and 7. Thus, in Fig. 7, an analog-to-digital converter system 111 is comprised of a first multiplexer 112 and a second multiplexer 113, a converting unit 114, and a combining unit 115 to provide a digital signal to a digital signal processor 116 via a digital signal bus 118. Converter unit 114 includes a first converting section 120 and a second converting section 122; first converting section 120 is clocked by a clocking signal φ₃ and second converting section 122 is clocked by a clocking signal φ₄. Analog signal samples are received by first converting section 120 via an analog input line 124a and second converting section 122 receives analog signal samples via an analog input line 124b. First multiplexer 112 accommodates received analog signals from channel 1, channel 2, channel 3, and channel 4, separately sampling those respective analog signals and providing analog signal samples to a line 123. Analog input line 124a is connected with line 123; second multiplexing unit 113 in the form of a sample-and-hold circuit receives signals via line 123 and, in response to a clocking signal φ₂ provides samples of signals received via line 123 to second converting section 122 via analog input line 124b.

Thus, received analog signals arriving via channel 1 are sampled and analog signal samples are provided to line 123 through a switch 126 in response to clocking signal φ₁. Received analog signals arriving via channel 2 are sampled and analog signal samples are provided to line 123 via a switch 128 in response to clocking signal φ₁; received analog signals arriving via channel 3 are sampled and analog signal samples are provided to line 123 via a switch 130 in response to clocking signal φ₁; received analog signals arriving via channel 4 are sampled and analog signal samples are provided to line 123 via a switch 132 in response to clocking signal φ₁. Most-significant bit segments of digital representations of a received analog signal arriving via channels 1-4 (received by converting unit 114 as analog signal samples via analog input line 124a from line 123) are passed to combining unit 115 from first converting section 120 via a bus 134. Least-significant bit segments of a digital representation of received analog signals arriving via channels 1-4 (received by sample-and-hold circuit 113 from line 123) are passed from sample-and-hold circuit 113 via line 124b to second converting section 122 of converting unit 114. Those least-significant bit segments are passed from second converting section 122 to combining unit 115 via a bus 136. Combining unit 115 combines most-significant bit segments received via bus 134 and least-significant bit segments received via bus 136 to produce a digital representation for each analog signal sample arriving via channels 1-4 and analog input lines 124a, 124b on digital signal bus 118 for provision to digital signal processor 116.

The employment of sample-and-hold circuit 113 obviates any need for concern regarding the relative frequencies of clocking signals φ₁ and φ₂ since the analog signal samples provided to first converting section 120 and to second converting section 122 are contemporaneous samples.

The timing diagram illustrated in Fig. 6 in connection with the preferred embodiment of the present invention illustrated in Fig. 4 applies equally in describing the alternate embodiment of the present invention illustrated in Fig. 7.

It is to be understood that, while the detailed drawing and specific examples given describe preferred embodiments of the invention, they are for the purpose of illustration, that the apparatus of the invention is not limited to the precise details and conditions disclosed and that various changes may be made therein without departing from the spirit of the invention which is defined by the following claims:

## Claims

1. An apparatus for converting a plurality of received analog signals to a plurality of output digital signals, each respective analog signal of said plurality of analog signals being received at a respective input channel and being converted to a respective output digital signal of said plurality of output digital signals; the apparatus comprising:
an analog-to-digital converting means for effecting conversion of a sample of a received analog signal to a digital representation of said sample, said digital representation having a predetermined number of digits hierarchically arranged from a least-significant digit to a most-significant digit; said analog-to-digital converting means including a first converting section for generating a most-significant segment of said digital representation, and a second converting section for generating a least-significant segment of said digital representation; said most significant segment being m most-significant digits of said digital representation; said least-significant segment being n-m least significant digits of said digital representation, where n equals the number of said predetermined digits;
a multiplexing means for presenting samples of said plurality of received analog signals to said analog-to-digital converting means; each said respective analog signal being received by said multiplexing means by a respective input channel; said multiplexing means being operatively connected with said analog-to-digital converting means for delivering said plurality of analog signals to said analog-to-digital converting means in a predetermined sequence, each respective analog signal of said plurality of analog signals being delivered in a first sample packet to said first converting section in response to a first clocking signal and in a second sample packet to said second converting section in response to a second clocking signal; and
a combining means for combining said most-significant segment with said least-significant segment for each said respective digital representation and generating said respective output digital signal.

2. An apparatus for converting a plurality of received analog signals to a plurality of output digital signals as recited in Claim 1 wherein said predetermined sequence is a seriatim sequence.

3. An apparatus for converting a plurality of received analog signals to a plurality of output digital signals as recited in Claim 2 wherein said predetermined sequence is cyclical.

4. An apparatus for converting a plurality of received analog signals to a plurality of output digital signals as recited in Claim 1 wherein said first clocking signal precedes said second clocking signal.

5. An apparatus for converting a plurality of received analog signals to a plurality of output digital signals as recited in Claim 2 wherein said first clocking signal precedes said second clocking signal.

6. An apparatus for converting a plurality of received analog signals to a plurality of output digital signals as recited in Claim 3 wherein said first clocking signal precedes said second clocking signal.

7. A system for increasing the rate of conversion of a received analog signal to an output digital signal representative of said analog signal by a half-flash analog-to-digital converting device; said half-flash converting device including a first converting section for converting most-significant digits of said output digital signal and a second converting section for converting least-significant digits of said output digital signal; the apparatus comprising:
a multiplexing means for multiplexing said analog signal according to a first clocking signal and a second clocking signal, said multiplexing means being operatively connected with said half-flash converting device and responding to said first clocking signal to provide said analog signal to said first converting section, said first converting section generating a first digital representation of said analog signal composed of a predetermined number of most-significant digits of said output digital signal; said multiplexing means responding to said second clocking signal to provide said analog signal to said second converting section, said second converting section generating a second digital representation of said analog signal composed of a predetermined number of least-significant digits of said digital signal; said predetermined most-significant digits and said predetermined least-significant digits comprising all digits of said output digital signal; and
a combining means operatively connected with said first converting section and with said second converting section for combining said first digital representation and said second digital representation to produce said digital signal.

8. An apparatus for converting a plurality of analog signals to a plurality of digital signals; the apparatus comprising:
a multiplexing means for multiplexing said plurality of analog signals; said multiplexing means delivering each analog signal of said plurality of analog signals in a predetermined cyclic order; each analog signal of said plurality of analog signals being delivered in a first analog sample packet and a second analog sample packet, said first analog sample packet being delivered in response to a first clock signal and said second analog sample packet being delivered in response to a second clock signal;
a converting means for converting each respective said first analog sample packet to a respective first digital signal packet and for converting each respective said second analog sample packet to a respective second digital signal packet; said converting means being operatively connected with said multiplexing means to receive each respective said first analog sample packet at a first converter section and to receive each respective said second analog sample packet at a second converter section; said first converter section converting each respective said first analog sample packet to a respective said first digital signal packet, said second converter section converting each respective said second analog sample packet to a respective said second digital signal packet; and
a combining means for combining signals; said combining means being operatively connected with said converting means for receiving and combining each respective said first digital signal packet and each respective said second digital signal packet to generate a respective digital signal of said plurality of digital signals.
